# EUROPÄISCHE PATENTSCHRIFT

(11) **EP 0 777 126 B1**
(45) Veröffentlichungstag und Bekanntmachung des Hinweises auf die Patenterteilung: **15.12.1999**
(21) Anmeldenummer: 97100294.4
(22) Anmeldetag: 14.09.1994
(51) Int. Cl.: G01R 31/00

(54) **Vorrichtung zur Einstellung von Parametern und/oder Betriebszuständen in elektrischen Werkstattgeräten**
Parameter determining means and/or mode determining means for electrical appliances
Dispositif pour régler des paramètres et/ou des modes de fonctionnement dans des installations électriques

(30) Priorität: 04.10.1993 DE 4333824
(43) Veröffentlichungstag der Anmeldung: 04.06.1997
(62) Teilanmeldung aus: 94926775.1
(73) Patentinhaber: ROBERT BOSCH GMBH, 70442 Stuttgart (DE)
(72) Erfinder: Anlauf, Jürgen, 73035 Göppingen (DE); Roth, Rolf, 73119 Zell (DE)

(56) Entgegenhaltungen:
- EP-A- 0 221 383
- WO-A-93/08654
- DE-A- 4 131 341

## Beschreibung

### Stand der Technik

Die Erfindung betrifft eine Vorrichtung zur Einstellung von Parametern und/oder Betriebszuständen in elektrischen Werkstattgeräte, insbesondere zur Sendefrequenzeinstellung in Sendemodulen zur Übertragung von Meßwerten.

Derartige, beispielsweise aus der DE-OS-35 38 687 oder der DE-OS-41 31 341 bekannte Vorrichtungen werden zweckmäßigerweise überall dort eingesetzt, wo Meßwerte von einem bewegten Objekt, beispielsweise einem Fahrzeug, zu einer Auswertestation, beispielsweise einem Diagnosegerät, übertragen werden sollen. Eine bevorzugte Anwendung erfolgt bei der Kraftfahrzeug-Diagnose, bei der die unterschiedlichsten Meßwerte zur Echtzeit-Meßwertübertragung über eine Hochfrequenz-Funkverbindung übertragen werden. Beispielsweise müssen bei einem Bremsdruck-Meßsystem verschiedene Drücke an verschiedenen Stellen des Bremssystems erfaßt und zur Auswertung übertragen werden.

Diese als Sendemodule ausgebildete Vorrichtungen müssen häufig nicht zuletzt auch in Abhängigkeit der örtlichen Gegebenheiten unter jeweils dort vorhandener elektromagnetischer Strahlung auf verschiedene Funkkanäle abgestimmt werden. Hierzu dienen in bekannter Weise beispielsweise DIP-Schalter. Die Sendemodule sind jedoch durch ihre Anbringung am Fahrzeug starker Beanspruchung unter anderem durch Schmutzwasser ausgesetzt, so daß eine sorgfältige Abdichtung des Modulgehäuses erforderlich ist. Dem steht die leichte Zugänglichkeit des DIP-Schalters als konträre Forderung gegenüber.

Auch bei anderen Werkstattgeräten, wie beispielsweise Eigendiagnosegeräten und Abgastestgeräten tritt diese Forderung auf, das Gerät möglichst hermetisch gegen Schmutz und Spritzwasser abzudichten, so daß Schalter zur Einstellung von Parametern oder Betriebszuständen möglichst zu vermeiden sind oder so geschützt eingebaut werden sollten, daß eine leichte Zugänglichkeit nicht mehr gegeben ist. Solche Einstellungen betreffen beispielsweise neben der Einstellung von Sendefrequenzen die Einstellung von Meßbereichen, Umschaltungen zwischen verschiedenen Meßwerterfassungen, Umschaltung zwischen Betriebszuständen (z. B. Ein/Aus) und dergleichen.

### Vorteile der Erfindung

Die erfindungsgemäße Vorrichtung mit den kennzeichnenden Merkmalen des Anspruchs 1 hat demgegenüber den Vorteil, daß auf Schalter weitgehend oder vollständig verzichtet werden kann und die nötigen Einstellungen von Parametern und/oder Betriebszuständen berührungslos über eine ohnehin erforderliche Ladeeinrichtung zur Aufladung eines im Werkstattgerät angeordneten Akkus erfolgen können. Das Werkstattgerät kann dadurch ein hermetisch abgedichtetes Gehäuse aufweisen, das keine überstehenden Schaltelemente oder dergleichen aufweist, die Ursache von Beschädigungen sein können.

Durch die in den Unteransprüchen aufgeführten Maßnahmen sind vorteilhafte Weiterbildungen und Verbesserungen der in dem Anspruch 1 angegebenen Vorrichtung möglich.

Bei einer Übertragung der Einstellsignale über die Ladeeinrichtung des im Werkstattgerät vorhandenen Akkus kann die Ladeeinrichtung in vorteilhafter Weise zur induktiven Übertragung des Ladestroms und der Einstellsignale als Ladespule ausgebildet sein. Es ist selbstverständlich prinzipiell auch möglich, die Ladeeinrichtung als abgedichteten Ladestecker am Gehäuse des Werkstattgeräts auszubilden.

Zur Speicherung der durch die Einstellsignale vorgegebenen Parameter und/oder Betriebszustände eignet sich ein nichtflüchtiger Speicher im Werkstattgerät, der vorzugsweise als batteriegepuffertes RAM oder als EEPROM ausgebildet ist.

Um die vorgenommenen Einstellungen ablesen und überprüfen zu können, ist ein Display zur Wiedergabe dieser Parameter und Betriebszustände am Gehäuse des Werkstattgeräts von Vorteil.

Die vorliegende Erfindung eignet sich vor allem für als Sendemodule ausgebildete Werkstattgeräte, wobei die Steuereinrichtung als Umschalteinrichtung für verschiedene vorgegebene Sendefrequenzen ausgebildet ist. Das Gehäuse weist zur Übertragung von Meßwerten insbesondere Sensoren zur Erfassung dieser Meßwerte, wie Druck, Temperatur, Abgaszusammensetzung, Drehzahl oder dergleichen auf, deren Signale einer Sendeeinrichtung zugeführt werden.

### Zeichnung

Ausführungsbeispiele der Erfindung sind in der Zeichnung dargestellt und in der nachfolgenden Beschreibung näher erläutert. Es zeigen:
- Figur 1: ein Ausführungsbeispiel eines Sendemoduls mit einer Einstellung der Sendefrequenzen über ein Ladegerät.
- Figur 2: eine Empfangsstation zum Empfang der vom Sendemodul übertragenen Meßwerte.

### Beschreibung der Ausführungsbeispiele

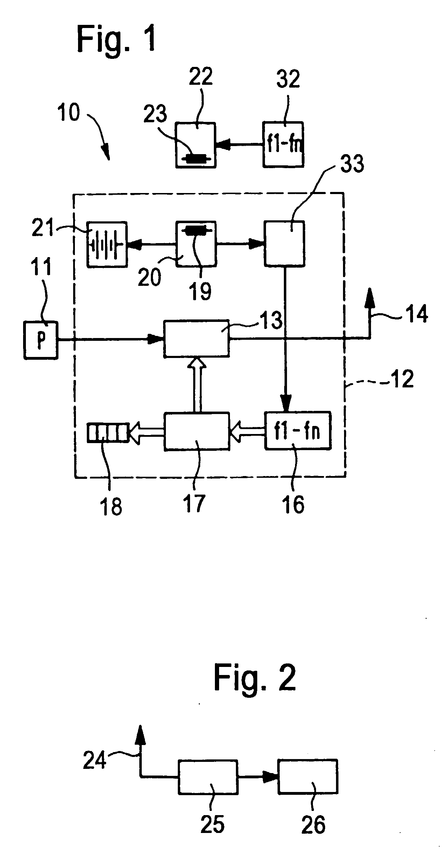

Das in Fig. 1 als erstes Ausführungsbeispiel dargestellte Sendemodul 10 besitzt einen Drucksensor 11 zur Erfassung beispielsweise des Bremsdrucks eines Lastkraftwagens, der überwacht oder überprüft werden soll. Hierzu werden üblicherweise mehrere derartige Sendemodule 10 an verschiedenen Stellen des Bremssystems eines Lastkraftwagens oder eines anderen Kraftfahrzeuges angebracht. Das Bremssystem weist hierzu entsprechende Meßöffnungen, insbesondere Schrauböffnungen auf, in die der Drucksensor oder eine mit einem Drucksensor verbundene Leitung eingeschraubt wird. Der Drucksensor 11 kann dabei am Gehäuse 12 des Sendemoduls angebracht oder mit diesem über eine Leitung verbunden sein. Mehrere solcher Sendemodule 10 dienen dabei zur Übertragung des Drucks an verschiedenen Stellen, während ein weiteres Sendemodul 10 zur Erfassung eines Referenzdrucks dient und beispielsweise an einem Bremsdruck-Kupplungskopf des Lastkraftwagens angeordnet ist.

Der Drucksensor 11 ist dabei mit einer Sendestufe 13 im Inneren des Sendemoduls 10 verbunden, die einen Modulator besitzt, um das Meßsignal des Drucksensors 11 auf ein hochfrequentes Sendesignal aufzumodulieren, das über eine Antenne 14 abgestrahlt wird.

In Fig. 2 ist eine Empfangsstation für die hochfrequent übertragenen Meßwerte dargestellt. Sie enthält eine mit einer Empfangsantenne 24 versehene Empfangsstufe 25, wobei die Empfangsstufe 25 wiederum einen nicht dargestellten Demodulator besitzt, über den das demodulierte Meßsignal einem Auswertegerät 26 zugeführt wird, das beispielsweise als Computer ausgebildet ist.

Prinzipiell können alle Sendemodule 10 mit derselben Sendefrequenz arbeiten, wobei dann eine zyklische Abfrage von Seiten der Empfangsstufe 25 oder ein zyklischer, synchronisierter Betrieb erforderlich ist. Andererseits ist es auch möglich, jedes Sendemodul 10 mit einer anderen Sendefrequenz zu beaufschlagen, wobei die Empfangsstufe 25 dann zum Empfang von Meßsignalen auf verschiedenen Kanälen ausgebildet ist. Auch wenn alle Sendemodule 10 mit derselben Sendefrequenz arbeiten, soll dennoch eine Kanalumschaltung dadurch erforderlich werden, wenn im aktuellen Frequenzkanal Störungen auftreten. Auch aus anderen Gründen kann eine Umschaltung erforderlich sein.

Auf diese Weise werden nacheinander alle verwendeten Sendemodule 10 auf die gewünschte Sendefrequenz eingestellt. Es ist auch möglich, das Ein- und Ausschalten des Sendemoduls 10 zu bewirken oder noch andere Umschaltvorgänge auszuführen.

Da derartige Sendemodule 10 nach der Benutzung üblicherweise in Ladeboxen aufbewahrt werden, um den Akku 21 wieder aufzuladen, kann über den Ladestrom auch gleichzeitig die Codierung der Sendefrequenz vorgenommen werden. Der Ladestrom wird induktiv vom Ladegerät 22 mittels der Ladespulen 23 und 19 auf die Ladeeinrichtung 20 übertragen und nach erfolgter Gleichrichtung zur Aufladung des Akkus 21 eingesetzt. Gleichzeitig wird dem Ladegerät 22 mittels der Codiereinrichtung 32 eine Codierungsinformaition zugeleitet, die als dynamisches Signal auf die Ladeeinrichtung 20 mitübertragen wird. Diese Ladeinformation wird mittels einer Trennstufe 33 abgetrennt und der Decodiereinrichtung 16 zugeführt, die in Abhängigkeit der empfangenen Signale eine Umschaltung zwischen vorgesehenen Sendefrequenzen f1 bis fn vornimmt und daher als Umschalteinrichtung wirkt. Ein einer angewählten Sendefrequenz entsprechenden Datenwort wird in einem nachgeschalteten Speicher 17 gespeichert, der dieses Datenwort zur Vorgabe der Sendefrequenz der Sendestufe 13 zuführt. Diese weist hierzu einen entsprechenden Umsetzer auf. Weiterhin wird dieses Datenwort einem Display 18 zugeführt, um die angewählte Sendefrequenz ablesen zu können.

Weiterhin besitzt das Sendemodul 10 noch eine mit einer Ladespule 19 versehene Ladeeinrichtung 20 zur Aufladung des aufladbaren Akkus 21, der in nicht dargestellter Weise zur Stromversorgung mit den einzelnen Komponenten des Sendemoduls 10 verbunden ist. Der Speicher 17 ist beispielsweise als RAM-Speicher ausgebildet und wird von diesem Akku 21 gepuffert, so daß er seinen Speicherinhalt immer behält. Anstelle eines batteriegepufferten RAM-Speichers kann auch beispielsweise ein EEPROM-Speicher treten. Der Ladestrom wird induktiv von einem Ladegerät 22, das ebenfalls eine Ladespule 23 besitzt, auf die Ladespule 19 der Ladeeinrichtung 20 übertragen. Selbstverständlich kann prinzipiell anstelle einer induktiven Aufladung eine Aufladung über ein Ladekabel und einen Ladestecker am Gehäuse 12 des Sendemoduls 10 treten. Die Codiereinrichtung kann mit entsprechenden Bedienungselementen versehen sein, die zur Vereinfachung nicht dargestellt sind.

Soll die Sendefrequenz des Sendemoduls 10 das erste Mal vorgegeben werden ode r eine vorgegebene Sendefrequenz geändert werden, so wird die gewünschte Sendefrequenz am Bedienungselement eingestellt, das beispielsweise als Drehschalter oder als Tastatur ausgebildet ist. Mit Hilfe einer Sendetaste wird nun ein mit der entsprechenden Information versehenes Signal, das beispielsweise moduliert sein kann, zur Ladeeinrichtung 20 abgesandt. Ein bei gewünschter Frequenz entsprechendes Datenwort wird im Speicher 17 gespeichert und kann über das Display 18 wiedergegeben werden, so daß die eingestellte Frequenz abgelesen werden kann. Gleichzeitig wird über das gespeicherte Datenwort die neue Sendefrequenz in der Sendestufe 13 vorgegeben, so daß die gemessenen Druckwerte nur mit dieser neuen Frequenz zur Empfangsstation übertragen werden.

Anstelle einer induktiven Aufladung des Akkus 21 kann das Ladegerät 22 selbstverständlich auch in herkömmlicher Weise den Ladestrom über ein Ladekabel dem Akku 21 zuführen. In diesem Falle ist die Ladeeinrichtung 20 als Ladestecker bzw. Ladebuchse ausgebildet.

Die Erfindung ist nicht auf Sendemodule beschränkt, sondern ist auch für andere Werkstattgeräte anwendbar, die im rauhen Werkstattbetrieb zur Vermeidung von Schmutz- und Feuchtigkeitseinwirkungen hermetisch abgeschlossene Gehäuse haben sollten, und bei denen aus diesem Grunde weitgehend oder vollständig auf äußere, manuelle Schaltelemente verzichtet werden soll. Mit Hilfe der Codierung von Parametern und Betriebszuständen über die Aufladeeinrichtung für den Akku gemäß dem Ausführungsbeispiel können derartig abgeschlossene Gehäuse leicht realisiert werden, und die Schaltvorgänge, beispielsweise zum Umschalten von Meßbereichen, Meßwerterfassungen, Betriebszuständen (Ein/Aus) und dergleichen können entsprechend der beschriebenen Art der Umschaltung zwischen Sendefrequenzen vorgenommen werden.

## Patentansprüche

1. Vorrichtung zur Diagnose von Kraftfahrzeugen, mit einem Sendemodul (10), das die erfaßten Meßwerte hochfrequent zu einer Empfangsstation überträgt, dadurch gekennzeichnet, daß das Sendemodul (10) zur Stromversorgung mit einem aufladbaren Akku (21) versehen ist, der über eine im Sendemodul (10) enthaltene Ladeeinrichtung (20) und ein separates Ladegerät (22) aufladbar ist, daß das Ladegerät (22) zusätzlich zur Übertragung von Signalen, die ein Einstellgerät (32) zur Einstellung von Parametern und/oder Betriebszuständen des Sendemoduls (10) bereitstellt, ausgebildet ist, daß die Ladeeinrichtung (20) zusätzlich zum Empfang der Einstellsignale ausgebildet ist, und daß das Sendemodul (10) eine die empfangenen Einstellsignale in elektrische Schaltsignale zur Einstellung der entsprechenden Parameter und/oder Betriebszustände umsetzende Steuereinrichtung (16) enthält.

2. Vorrichtung nach Anspruch 1, dadurch gekennzeichnet, daß die Ladeeinrichtung (20) zur induktiven Übertragung des Ladestroms und der Einstellsignale eine Ladespule (19) aufweist.

3. Vorrichtung nach einem der vorhergehenden Ansprüche, dadurch gekennzeichnet, daß ein nicht flüchtiger Speicher (17) zur Speicherung der durch die Einstellsignale vorgegebenen Parameter und/oder Betriebszustände enthalten ist.

4. Vorrichtung nach Anspruch 3, dadurch gekennzeichnet, daß der nicht flüchtige Speicher (17) als batteriegepuffertes RAM oder als EEPROM ausgebildet ist.

5. Vorrichtung nach Anspruch 3 oder 4, dadurch gekennzeichnet, daß ein Display (18) zur Wiedergabe der eingestellten Parameter und/oder Betriebszustände am Gehäuse (12) des Werkstattgeräts (10) angeordnet ist.

6. Vorrichtung nach einem der vorhergehenden Ansprüche, dadurch gekennzeichnet, daß die Steuereinrichtung (16) als Umschalteinrichtung für verschiedene vorgegebene Sendefrequenzen des als Sendemodul ausgebildeten Werkstattgeräts (10) ausgebildet ist.

7. Vorrichtung nach Anspruch 6, dadurch gekennzeichnet, daß das Gehäuse (12) Sensoren (11) zur Erfassung von Meßwerten, wie Druck, Temperatur, Abgaszusammensetzung, Drehzahl aufweist oder mit diesen verbunden ist, deren Signale einer Sendeeinrichtung (13) zugeführt werden.

## Claims

1. Device for diagnosing motor vehicles, having a transmission module (10) which transmits the sensed measured values to a reception station at high frequency, characterized in that to supply the transmission module (10) with power it is provided with a rechargeable battery (21) which can be charged via a charging device (20) contained in the transmission module (10) and via a separate charging unit (22), in that the charging unit (22) is additionally designed for transmitting signals made available by a setting unit (32) for setting parameters and/or operating states of the transmission module (10), in that the charging device (20) is additionally designed for receiving the setting signals, and in that the transmission module (10) contains a control device (16) which converts the received setting signals into electrical switching signals for setting the corresponding parameters and/or operating states.

2. Device according to Claim 1, characterised in that the charging device (20) has a charging coil (19) for inductively transmitting the charging current and the setting signals.

3. Device according to one of the preceding claims, characterized in that a non-volatile memory (17) for storing the parameters and/or operating states provided by the setting signals is included.

4. Device according to Claim 3, characterized in that the non-volatile memory (17) is designed as a battery-buffered RAM or as an EEPROM.

5. Device according to Claim 3 or 4, characterized in that a display (18) for representing the parameters and/or operating states which have been set is arranged on the housing (12) of the workshop apparatus (10).

6. Device according to one of the preceding claims, characterized in that the control device (16) is designed as a switch-over device for various prescribed transmission frequencies of the workshop apparatus (10) which is designed as a transmission module.

7. Device according to Claim 6, characterized in that the housing (12) has sensors (11) for sensing measured values such as pressure, temperature, exhaust-gas composition, rotational speed or is connected to said sensors (11) whose signals are fed to a transmission device (13).

## Revendications

1. Dispositif de diagnostic pour des véhicules à moteur, avec un module d'émission (10) qui transmet les valeurs de mesure captées à haute fréquence, à une station de réception,
caractérisé en ce que
• le module d'émission (10) est pourvu pour son alimentation en courant, d'un accumulateur rechargeable (21) qui peut être chargé au moyen d'un système de charge (20) contenu dans le module d'émission (10), et d'un appareil de charge séparé (22),
• l'appareil de charge (22) est constitué en plus pour transmettre des signaux préparés par un appareil de réglage (32) servant à régler des paramètres et/ou des états de fonctionnement du module d'émission (10),
• le système de charge (20) est constitué en plus pour recevoir les signaux de réglage,
• le module d'émission (10) contient un système de commande (16) qui convertit les signaux de réglage reçus en des signaux électriques de commande pour régler les paramètres et/ou les états de fonctionnement correspondants.

2. Dispositif selon la revendication 1,
caractérisé en ce que
le système de charge (20) présente une bobine de charge (19) pour transmettre par induction le courant de charge et les signaux de réglage

3. Dispositif selon l'une des revendications précédentes,
caractérisé en ce qu'
il contient une mémoire non volatile (17) pour mettre en mémoire les paramètres et/ou les états de fonctionnement prédéfinis par les signaux de réglage.

4. Dispositif selon la revendication 3,
caractérisé en ce que
la mémoire non volatile (17) est constituée sous la forme d'une mémoire vive RAM amortie par batterie, tampon ou d'une mémoire morte effaçable par voie électronique EEPROM.

5. Dispositif selon la revendication 3 ou 4,
caractérisé en ce qu'
un écran (18) qui sert à reproduire les paramètres et/ou les états de fonctionnement réglés, est disposé sur le boîtier (12) de l'appareil d'atelier (10).

6. Dispositif selon l'une des revendications précédentes,
caractérisé en ce que
le système de commande (16) est constitué sous la forme d'un système de commutation pour différentes fréquences d'émission prédéfinies de l'appareil d'atelier (10), constitué sous la forme du module d'émission.

7. Dispositif selon la revendication 6,
caractérisé en ce que
le boîtier (12) présente des capteurs (11) qui servent à détecter des valeurs de mesure telles que la pression, la température, la composition des gaz d'échappement, la vitesse de rotation, ou est relié à ceux-ci, les signaux de ces capteurs étant amenés à un système d'émission (13).
